## Europäisches Patentamt
## European Patent Office
## Office européen des brevets

(19)

(11) Veröffentlichungsnummer: **0 106 408**
**B1**

(12) # EUROPÄISCHE PATENTSCHRIFT

(45) Veröffentlichungstag der Patentschrifft: 28.02.90

(51) Int. Cl. ⁵: **H 03 G 1/00, G 08 G 1/09**

(21) Anmeldenummer: 83201447.6

(22) Anmeldetag: 10.10.83

(54) Schaltungsanordnung zur Lautstärkestellung.

(30) Priorität: 16.10.82 DE 3238459

(43) Veröffentlichungstag der Anmeldung: 25.04.84 Patentblatt 84/17

(45) Bekanntmachung des Hinweises auf die Patenterteilung: 28.02.90 Patentblatt 90/09

(84) Bennante Vertragsstaaten: AT CH DE LI

(56) Entgegenhaltungen:
DE-A-2 548 590
DE-C-881 216
US-A-3 356 949

(73) Patentinhaber: Philips Patentverwaltung GmbH Wendenstrasse 35 Postfach 10 51 49 D-2000 Hamburg 1 (DE)

(84) Bennante Vertragsstaaten: DE

(73) Patentinhaber: N.V. Philips' Gloeilampenfabrieken Groenewoudseweg 1 NL-5621 BA Eindhoven (NL)

(84) Bennante Vertragsstaaten: CH LI AT

(72) Erfinder: Dünnebacke, Joachim Augusta-Strasse 20 D-6348 Herborn (DE)

(74) Vertreter: Hartmann, Heinrich, Dipl.-Ing. Philips Patentverwaltung GmbH Wendenstrasse 35 Postfach 10 51 49 D-2000 Hamburg 1 (DE)

EP 0 106 408 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBERGRAF, STOCKHOLM 1990

## Beschreibung

Die Erfindung betrifft eine Schaltungsanordnung zur Lautstärkestellung mit einem Verstärker, dessen Verstärkung durch eine von einem ersten Gleichspannungsgeber gelieferte veränderbare Gleichspannung an einem Steuereingang steuerbar ist, mit Mitteln zum Anheben der Lautstärke beim Auftreten eines Steuersignals.

Eine solche Schaltungsanordnung kann in einem Verkehrsrundfunkempfänger sicherstellen, daß bei einer Verkehrsdurchsage, die durch ein Durchsagekennsignal begleitet ist, die Lautstärke einen Mindestwert aufweist. Sie kann jedoch auch bei einem Radiowecker benutzt werden, um zu erreichen, daß das Wecken mit einer Mindestlautstärke erfolgt.

Aus der DE-B-2 120 281 ist bereits eine Schaltungsanordnung zur Lautstärkestellung bekannt, bei der das NF-Signal einem Potentiometer zugeführt wird und an dessen Abgriff abnehmbar ist. Der Fußpunkt des Potentiometers ist ü}er einen Widerstand mit Masse verbunden, dem ein steuerbarer Schalter parallelgeschaltet ist. Solange der Schalter leitend ist, hängt die Lautstärke ausschließlich von der Stellung des Potentiometerabgriffs ab. Wird jedoch der Schalter. z. B. bei einer Verkehrsdurchsage, gesperrt, wird die Lautstärke angehoben. Wenn die Lautstärke vorher auf einen minimalen Wert eingestellt war, ist diese Anhebung verhältnismäßig stark; war die Lautstärke vorher jedoch auf einen maximalen Wert eingestellt, ist die Lautstärkeanhebung vergleichsweise gering, weil der Wert des Widerstandes wesentlich kleiner ist als der Potentiometerwiderstand.

Ein Nachteil dieser Schaltung besteht darin, daß das Niederfrequenzsignal selbst an dem Potentiometer abgegriffen wird und daß es ü}er relativ lange Leitungen mit dem Lautstärkeregler verbunden sein muß.

Dieser Nachteil wird durch die aus der DE-A-3 045 722 bekannte Schaltung der eingangs genannten Art vermieden. Das Niederfrequenzsignal wird dabei lediglich dem Verstärker zugeführt und die Lautstärke wird durch die vom ersten Gleichspannungsgeber gelieferte Gleichspannung eingestellt.

Der erste Gleichspannungsgeber wird dabei durch ein Potentiometer in der Emitterzuleitung eines Transistors gebildet, dessen Basis an einer konstanten Vorspannung liegt. Der Verstärker ist dabei derart aufgebaut, daß seine Verstärkung um so kleiner ist, je größer die Gleichspannung an seinem Steuereingang ist. Im Falle einer Verkehrsdurchsage wird die Vorspannung des Transistors um einen konstanten Betrag erniedrigt, so daß auch die Spannung an dem Potentiometer erniedrigt und die Verstärkung bzw. die Lautstärke angehoben wird. Die Anhebung der Lautstärke findet dabei auch dann statt, wenn vorher schon eine hohe Lautstärke eingestellt war. Dies ist insbesondere dann störend, wenn die Steuersteilheit (der Quotient aus Verstärkungsänderung und Gleichspannungsänderung) des Verstärkers besonders groß ist. Außerdem erfordert die bekannte Schaltung einen Verstärker, dessen Verstärkung mit zunehmender Gleichspannung abnimmt. Bei Verstärkern, deren Verstärkung mit zunehmender Gleichspannung am Steuereingang zunimmt, wäre das bekannte Prinzip nicht anwendbar, weil dabei die Lautstärkeanhebung bei hohen Lautstärken größer wäre als bei geringen Lautstärken.

Aufgabe der Erfindung ist es, eine Schaltungsanordnung der eingangs genannten Art so auszubilden, daß beim Auftreten eines Steuersignals die Lautstärke nur dann angehoben wird, wenn sie vorher unterhalb eines vorgebbaren Wertes lag. Diese Aufgabe wird erfindungsgemäß dadurch gelöst, daß ein zweiter Gleichspannungsgeber vorgesehen ist, dessen Ausgangsgleichspannung durch das Steuersignal von einem ersten Gleichspannungswert auf einen zweiten Gleichspannungswert umschaltbar ist und daß der Ausgang des zweiten Gleichspannungsgebers mit dem Steuereingang ü}er ein Diodenelement verbunden ist, dessen Durchlaßrichtung so gewählt ist, daß es gesperrt ist, wenn der erste Gleichspannungswert am Ausgang des zweiten Gleichspannungsgebers anliegt.

Wenn der zweite Gleichspannungsgeber auf den ersten Gleichspannungswert eingestellt wird, d.h. wenn das Steuersignal fehlt, wird die Lautstärke ausschließlich durch den ersten Gleichspannungsgeber bestimmt, weil das Diodenelement, das durch eine Diode oder einen Zweipol gebildet werden kann, dessen Widerstandswert (hochohmig oder niederohmig) durch die Polarität der ü}er ihm abfallenden Spannung bestimmt wird, dann gesperrt ist, so daß der erste Gleichspannungswert keinen Einfluß auf den Steuereingang haben kann.

Beim Auftreten des Steuersignals wird der zweite Gleichspannungsgeber auf den zweiten Gleichspannungswert umgeschaltet. In diesem Fall gibt es zwei Möglichkeiten.

a) Der zweite Gleichspannungswert entspricht einer größeren Lautstärke als die vom ersten Gleichspannungsgeber gelieferte Gleichspannung. In diesem Fall ist das Diodenelement leitend und die Spannung am Steuereingang des Verstärkers wird durch den zweiten Gleichspannungswert bestimmt, so daß die Lautstärke auf einen dem zweiten Gleichspannungswert entsprechenden Mindestwert angehoben wird.

b) Der zweite Gleichspannungswert entspricht - falls er direkt dem Steuereingang des Verstärkers zugeführt wird - einer niedrigeren Lautstärke als die Gleichspannung am Ausgang des ersten Gleichspannungsgebers. In diesem Fall ist das Diodenelement gesperrt und die Lautstärke wird ausschließlich durch den ersten Gleichspannungsgeber bestimmt.

Besonders gering wird der Aufwand für diese Schaltung, wenn der erste und der zweite Spannungsgeber durch Spannungsteiler gebildet werden.

Die Erfindung wird nachstehend anhand der Zeichnung näher erlätert. Es zeigen

Fig. 1 ein erstes Ausführungsbeispiel mit einem Verstärker, dessen Verstärkung mit zunehmender Gleichspannung zunimmt,

Fig. 2 ein Ausführungsbeispiel mit einem Verstärker, dessen Verstärkung mit zunehmender Gleichspannung an seinem Steuereingang abnimmt, und

Fig. 3 ein Ausführungsbeispiel, bei dem beim Auftreten eines Steuersignals ein definierter Strom geliefert wird.

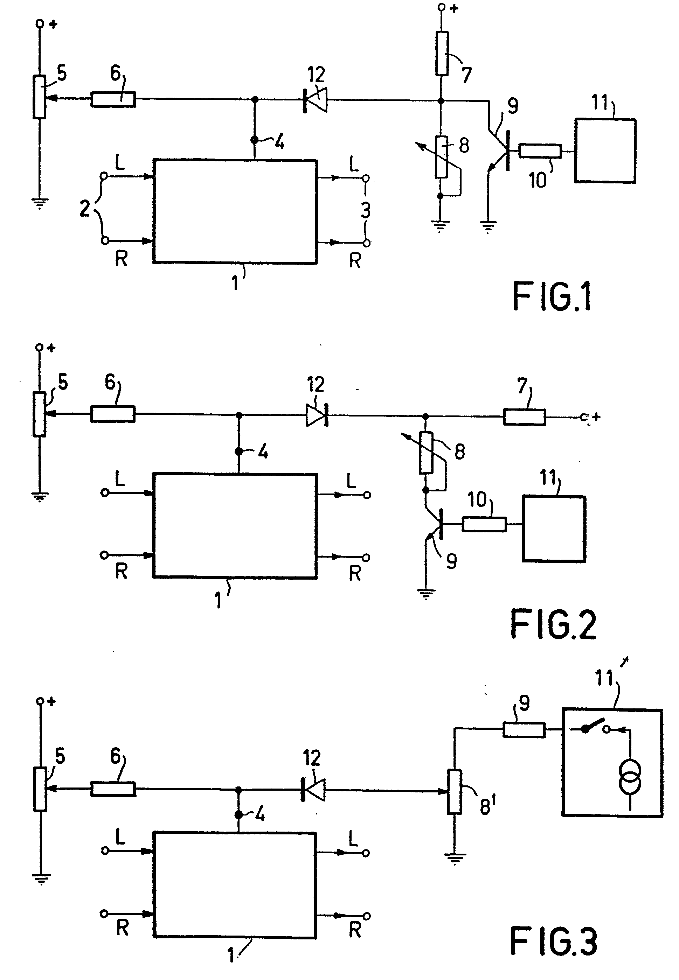

In Fig. 1 ist mit 1 ein zweikanaliger Verstärker - vorzugsweise einer integrierten Schaltung - bezeichnet, dessen Eingangsklemmen 2 ein Stereosignal zugeführt wird. Das Stereosignal an den Ausgangsklemmen 3 dieses Verstärkers wird einer nicht näher dargestellten Wiedergabeanordnung mit wenigstens zwei Lautsprechern zugeführt. Die Verstärkung des Stereosignals (die auch kleiner als 1 sein kann, was auch für alle anderen Ausführungsformen gilt), hängt von der Spannung am Steuereingang 4 dieses Verstärkers ab, und zwar in der Weise, daß die Verstärkung und damit die Lautstärke um so größer ist, je größer die Spannung am Steuereingang 4 ist.

Die Schaltung umfaßt zwei Gleichspannungsgeber. Der erste Gleichspannungsgeber wird durch ein Potentiometer 5 gebildet, das zwischen Masse und eine positive Gleichspannung geschaltet ist und dessen Abgriff ü}er einen Längswiderstand 6 mit dem Steuereingang 4 verbunden ist.

Der zweite Gleichspannungsgeber wird durch einen Spannungsteiler gebildet, der aus dem mit der positiven Speisespannung verbundenen Widerstand 7 und einem einstellbaren Widerstand 8 besteht, dessen zweiter Anschluß mit Masse verbunden ist. Parallel zu dem Widerstand 8 ist die Kollektor-Emitter-Strecke eines npn-Transistors 9 geschaltet, dessen Basis ü}er einen Vorwiderstand 10 mit einem Detektor 11 verbunden ist, beispielsweise einem Verkehrsfunkdetektor, der beim Auftreten eines Durchsage-Kennsignals den Transistor 9 sperrt und ihn beim Fehlen eines Durchsage-Kennsignals leitend macht.

Am Verbindungspunkt der Widerstände 7 und 8, d.h. am Ausgang des zweiten Gleichspannungsgebers, ergibt sich also ein erster Gleichspannungswert, wenn das Steuersignal bzw. das Durchsage-Kennsignal fehlt und ein zweiter Gleichspannungswert beim Auftreten des Steuersignals. Der erste Gleichspannungswert muß dabei so gewählt sein - und das gilt wiederum für alle Ausführungsformen - daß sich eine minimale Verstärkung bzw. Lautstärke ergä}e, wenn dieser Wert direkt am Steuereingang 4 anliegen würde. Der zweite Gleichspannungswert muß einer größeren Lautstärke entsprechen.

Der Verbindungspunkt der Widerstände 7 und 8 ist mit der Anode einer Diode 12 verbunden, deren Kathode mit dem Steuereingang 4 verbunden ist.

Die Schaltung arbeitet wie folgt:

Bei leitendem Transistor 9 ergibt sich am Ausgang des Gleichspannungsgebers 7... 9 der erste Gleichspannungswert, der einer Gleichspannung von nahezu 0 Volt entspricht. Deshalb ist die Diode 12 stets gesperrt und die Lautstärke wird ausschließlich durch die Stellung des Abgriffes des Potentiometers 5 bestimmt. Die Lautstärke ist um so größer, je positiver die Spannung an diesem Abgriff ist.

Beim Auftreten eines Steuersignals wird der Transistor 9 gesperrt, so daß sich am Ausgang des zweiten Gleichspannungsgebers eine Spannung ergibt, die durch die Größe des einstellbaren Widerstandes 8 bestimmt wird. Wenn die Spannung am Abgriff des Potentiometers 5 positiver ist, bleibt die Diode 12 gesperrt und die Lautstärke wird weiterhin durch die Spannung am Potentiometerabgriff bestimmt. Wenn jedoch die Spannung am Potentiometerabgriff (um die Durchlaßspannung der Diode 12) kleiner ist als der zweite Gleichspannungswert, wird die Diode 12 leitend. Die Lautstärke wird dann durch den zweiten Gleichspannungswert bestimmt, der mit Hilfe des Widerstandes 8 einstellbar ist. Dabei muß selbstverständlich dafür Sorge getragen werden, daß nicht trotz leitender Diode 12 die Gleichspannung am Steuereingang 4 durch den ersten Gleichspannungsgeber 5, 6 aufgeprägt wird; daher muß dieser genügend hochohmig sein, was durch den Längswiderstand 6 von 10 kOhm erreicht wird, der auch einen Kurzschluß verhindert, wenn der Abgriff des Potentiometers 5 praktisch mit Masse verbunden ist. Als Potentiometer 5 eignet sich ein lineares 50 kOhm-Potentiometer, während ein geeigneter Wert für den Widerstand 7 8,2 kOhm und für den Widerstand 8 5 kOhm ist. Anstelle des Transistorschalters 9 parallel zum Widerstand 8 könnte auch ein Transistorschalter in die Verbindungsleitung zwischen der Speisespannung und dem Widerstand 7 geschaltet werden. Allerdings wäre dann die Steuerung dieses Transistors, der beim Auftreten des Steuersignals leitend werden müßte, komplizierter.

Wenn zur Steuerung der Verstärkung des Verstärkers 1 an seinem Steuereingang 4 eine negative Gleichspannung benötigt würde, müßten das Potentiometer 5 und der Spannungsteiler 7 und 8 an eine negative Gleichspannung angeschlossen werden; der npn-Transistor 9 müßte durch einen pnp-Transistor ersetzt werden, der in die Zuleitung zwischen der Speisespannung und dem Widerstand 7 geschaltet ist und der beim Auftreten eines Steuersignals leitend wird, und die Polarität der Diode 12 müßte umgekehrt werden.

Das in Fig. 2 dargestellte Ausführungsbeispiel unterscheidet sich von demjenigen nach Fig. 1 dadurch, daß ein Verstärker verwendet wird, dessen Verstärkung um so geringer ist, je größer die positive Gleichspannung an seinem Steuereingang 4 ist. Die Schaltung nach Fig. 1 muß dafür nur geringfügig geändert werden. Zum einen muß die Durchlaßrichtung der Diode 12 umgetauscht werden, d.h. ihre Anode (und nicht ihre Kathode) muß mit dem Steuereingang 4 des Verstärkers ver}unden sein. Zum anderen muß der Schalttransistor 9 entweder parallel zum Festwiderstand 7 geschaltet werden oder - noch günstiger - durch einen npn-Transistor 9 ersetzt werden, dessen Kollektor-Emitter-Strecke zwischen den einstellbaren Widerstand 8 und Masse geschaltet ist und der beim Auftreten des Steuersignals leitend wird.

Beim Fehlen eines Steuersignals liegt am Ausgang des Gleichspannungsgebers 7... 9 dabei praktisch die positive Versorgungsspannung. die - wenn sie dem Steuereingang direkt zugeführt würde - dessen Verstärkung auf ihren Minimalwert herabsetzen würde. Da die Kathode der Diode 12 mit diesem Ausgang verbunden ist, ist sie in diesem Betriebszustand stets gesperrt, so daß die Lautstärke ausschließlich durch die Stellung des Potentiometerabgriffs bestimmt wird (wobei sie jedoch klein ist, wenn die Spannung am Steuereingang 4 groß ist, und groß, wenn diese Spannung klein ist). Beim Auftreten eines Steuersignals wird der Transistor 9 leitend, so daß die Spannung am Verbindungspunkt der Widerstände 7 und 8 einen niedrigeren Wert annimmt. Ist dieser Wert niedriger als die Spannung am Abgriff des Potentiometers 5, wird die Diode 12 leitend und die Gleichspannung am Steuereingang 4 wird in diesem Fall vom zweiten Gleichspannungsgeber 7... 9 bzw. durch den zweiten Gleichspannungswert bestimmt.

Die Ausführungsform nach Fig. 3 unterscheidet sich von derjenigen nach Fig. 1 dadurch, daß ein Detektor 11' verwendet wird, z. B. ein Microcomputer, der an einem Ausgang beim Auftreten eines Steuersignals einen definierten, von der äßeren Belastung unabhängigen Strom liefert und beim Fehlen des Steuersignals stromlos ist. Dieser Ausgang ist ü}er einen Begrenzungswiderstand 9 mit einem Potentiometer 8 einen einstellbaren Widerstand ersetzt werden.

Wenn bei der Schaltung nach Fig. 3 ein Verstärker verwendet worden wäre, dessen Verstärkung mit zunehmender (positiver) Gleichspannung abnimmt, müßte diese Schaltung wie folgt geändert werden: Die Kathode der Diode 12 muß mit dem Potentiometer verbunden werden; der Stromausgang des Detektors muß beim Auftreten des Steuersignals ein niedriges Potential aufweisen und das andere Ende des Potentiometers muß mit der positiven Speisespannung verbunden sein.

**Patentansprüche**

1. Schaltungsanordnung zur Lautstärkestellung mit einem Verstärker (1), dessen Verstärkung durch eine von einem ersten Gleichspannungsgeber (5) gelieferte veränderbare Gleichspannung an einem Steuereingang (4) steuerbar ist, mit Mitteln (7... 11) zum Anheben der Lautstärke beim Auftreten eines Steuersignals, *dadurch gekennzeichnet*, daß ein zweiter Gleichspannungsgeber (7... 11) vorgesehen ist, dessen Ausgangsgleichspannung durch das Steuersignal von einem ersten Gleichspannungswert auf einen zweiten Gleichspannungswert umschaltbar ist, und daß der Ausgang des zweiten Gleichspannungsgebers mit dem Steuereingang (4) ü}er ein Diodenelement (12) verbunden ist, dessen Durchlaßrichtung so gewählt ist, daß es gesperrt ist, wenn der erste Gleichspannungswert am Ausgang des zweiten Gleichspannungsgebers anliegt.

2. Schaltungsanordnung nach Anspruch 1, *dadurch gekennzeichnet*, daß der erste Gleichspannungsgeber ein Widerstandsspannungsteiler (5) ist und dessen Abgriff ü}er einen Widerstand (6) mit dem Steuereingang (4) des Verstärkers (1) verbunden ist.

3. Schaltungsanordnung nach Anspruch 1 oder 2, *dadurch gekennzeichnet*, daß der zweite Gleichspannungsgeber ein Spannungsteiler (7, 8) ist und daß ein durch das Steuersignal schaltbarer Schalter (9) in Serie oder parallel zu einem Teil des Spannungsteilers geschaltet ist.

4. Schaltungsanordnung nach Anspruch 1 oder 2, wobei durch das Steuersignal eine Stromquelle eingeschaltet wird, *dadurch gekennzeichnet*, daß der zweite Gleichspannungsgeber durch einen an die Stromquelle (11') angeschlossenen einstellbaren Widerstand (8) gebildet wird.

**Claims**

1. A circuit arrangement for sound volume control, comprising an amplifier (1) whose gain is controllable by means of a variable DC voltage at a control input (4), which voltage is supplied by a first DC voltage generator (5), and means (7... 11) for raising the sound volume when a control signal occurs, characterized in that a second voltage generator (7... 11) is provided whose DC output voltage is switchable from a first DC voltage value to a second DC voltage value by means of the control signal, and in that the output of the second DC voltage generator is connected to the control input (4) via a diode element (12) whose pass direction is chosen to be such that it is blocked when the first DC voltage value is present at the output of the second DC voltage generator.

2. A circuit arrangement as claimed in Claim 1, characterized in that the first DC voltage generator is a resistance voltage divider (5) whose tap is connected to the control input (4) of the amplifier (1) via a resistor (6).

3. A circuit arrangement as claimed in Claim 1 or 2, characterized in that the second DC voltage generator is a voltage divider (7, 8) and in that a switch (9) which is switchable by means of the control signal is arranged in series with or parallel to a part of the voltage divider.

4. A circuit arrangement as claimed in Claim 1 or 2, in which a current source is switched on by means of the control signal, characterized in that the second DC voltage generator is constituted by an adjustable resistor (8) which is connected to the current source (11').

**Revendications**

1. Montage de circuit pour la commande du volume sonore au moyen d'un amplificateur (1) dont l'amplification peut être commandée par une tension continue variable fournie par un premier générateur de tension continue (5) à une entrée de commande (4) comportant des moyens (7 ... 11) pour augmenter le volume sonore à l'apparition d'un signal de commande, caractérisé en ce qu'il est prévu un second générateur de tension continue (7 ... 11), dont la tension continue de sortie peut être commutée par le signal de commande d'une première valeur de tension continue sur une seconde valeur de tension continue, et que la sortie du second générateur de tension continue est connectée à l'entrée de commande (4) par l'intermédiaire d'un élément à diode (12) dont le sens passant est choisi tel qu'il soit bloqué si la première valeur de tension continue est présente à la sortie du second générateur de tension continue.

2. Montage de circuit suivant la revendication 1, caractérisé en ce que le premier générateur de tension continue est un diviseur de tension à résistance (5) et que sa prise est connectée par une résistance (6) à l'entrée de commande (4) de l'amplificateur (1).

3. Montage de circuit suivant la revendication 1 ou 2, caractérisé en ce que le second générateur de tension continue est un diviseur de tension (7, 8) et qu'un commutateur (9) pouvant être commuté par le signal de commande est monté en série ou en parallèle à une partie du diviseur de tension.

4. Montage de circuit suivant la revendication 1 ou 2, dans lequel le signal de commande enclenche une source de courant, caractérisé en ce que le second générateur de tension continue est constitué par une résistance réglable (8) connectée à la source de courant (11').

FIG.1

FIG.2

FIG.3